# EUROPEAN PATENT SPECIFICATION

(11) **EP 2 084 735 B1**
(45) Date of publication and mention of the grant of the patent: **18.06.2014**
(21) Application number: 07844101.1
(22) Date of filing: 10.10.2007
(51) Int. Cl.: H01L 21/31, C23C 16/455

(54) **TEMPERATURE CONTROLLED MULTI-GAS DISTRIBUTION ASSEMBLY**
TEMPERATURGEREGELTE MEHRFACH-GASVERTEILERBAUGRUPPE
ENSEMBLE DE DISTRIBUTION DE PLUSIEURS GAZ À RÉGULATION DE TEMPÉRATURE

(30) Priority: 26.10.2006 US 553340
(43) Date of publication of application: 05.08.2009
(73) Proprietor: Applied Materials, Inc., Santa Clara, CA 95054 (US)
(72) Inventor: MYO, Nyi Oo, San Jose, CA 95124 (US); POPPE, Steven, Pleasanton, CA 94566 (US); MATTINGER, George, Cupertino, CA 95014 (US)
(74) Representative: Zimmermann & Partner
(86) International application number: PCT/US2007/080966
(87) International publication number: WO 2008/051717

(56) References cited:
- EP-A2- 1 168 420
- US-A- 6 108 189
- US-B1- 6 367 687
- US-B1- 6 444 039

## Description

### BACKGROUND OF THE INVENTION

### Field of the Invention

The invention relates to an apparatus for processing substrates, such as semiconductor wafers, and more particularly, to an apparatus for distribution of process fluids over a substrate.

### Description of the Related Art

Semiconductor processing systems generally include a process chamber having a pedestal for supporting a substrate, such as a semiconductor wafer, within the chamber proximate a processing region. The chamber forms a vacuum enclosure defining, in part, the processing region. A gas distribution assembly or showerhead provides one or more process gases to the processing region. The gases are then heated and/or energized to form a plasma which performs certain processes upon the substrate. These processes may include deposition processes, such as chemical vapor deposition (CVD), to deposit a film upon the substrate or an etch reaction to remove material from the substrate, among other processes.

Document EP 1 168 420 describes a gas supply nozzle plate which is constructed by laminating a plurality of metal members each having a fluid path and branch. A fluid nozzle plate member has high sealing at a joined part, and high reliability even when used in high vacuum or at a high temperature. The fluid nozzle plate member comprises a plurality of plate-like metal members each having a fluid path and/or a branch. In this case, the plurality of plate-like metal members are laminated, and the laminated surfaces thereof are joined together by press forging.

Furthermore, US 6,444,039 B1 describes a vapor supply apparatus, for use in a semiconductor device manufacturing process. The vapor supply apparatus provides a three-dimensional showerhead for supplying various precursors to a reaction chamber. The three-dimensional showerhead comprises an inverted-cup structure having double walls, an outer wall and an inner wall, with the double walls defining a first interior volume and the inner wall defining an exterior cavity, the inverted-cup structure further has a plurality of first inlet ports connected to the outer wall for introducing first precursors into the first interior volume and a plurality of first outlet ports at the inner wall for discharging the first precursor vapor from the first interior volume to the exterior cavity. The three-dimensional showerhead confines the precursor vapor inside the external cavity to modify the processed film characteristics

In processes that require multiple gases, the gases may be combined within a mixing chamber that is then coupled to the gas distribution assembly via a conduit. For example, in a conventional thermal CVD process, two process gases are supplied to a mixing chamber along with two respective carrier gases where they are combined to form a gaseous mixture. The gaseous mixture may be introduced directly to the chamber, or may travel through a conduit within an upper portion of the chamber to the distribution assembly. The distribution assembly generally includes a plate having a plurality of holes such that the gaseous mixture is evenly distributed into the processing region above the substrate. In another example, two gases pass through the distribution assembly separately, and allowed to combine before reaching the processing region and/or the substrate. As the gaseous mixture enters the processing region and is infused with thermal energy, a chemical reaction occurs between the process gases, resulting in a chemical vapor deposition reaction on the substrate.

Although it is generally advantageous to mix the gases prior to release into the processing region, for example, to ensure that the component gases are uniformly distributed into the processing region, the gases tend to begin reduction, or otherwise react, within the mixing chamber or distribution plate. Consequently, deposition on or etching of the mixing chamber, conduits, distribution plate, and other chamber components may result prior to the gaseous mixture reaching the processing region. Additionally, reaction by products may accumulate in the chamber gas delivery components or on the inside surface of the distribution plate, thus generating, and/or increasing the presence of, unwanted particles.

Temperature control of the gases as they are released into the processing region is advantageous for controlling the reactivity of the gases. For example, cooling the gases can be helpful in controlling unwanted reactions prior to release into the processing region. The gases refrain from reacting until they come into contact with a heated substrate. In other circumstances, heating of gases may be necessary. For example, hot gas purging or cleaning may help remove contaminants from a processing chamber. Thus, integrating a temperature control aspect into a gas distribution plate is useful.

While some gas distribution devices have been developed to minimize gas mixing prior to entry into the processing region, the devices may tend to prematurely deteriorate during processing. For example, conventional distribution devices may be made of materials that expand and contract during processing, leading to deterioration of the device or other parts of the processing chamber. The conventional devices may also require sealing with large elastomeric seals, such as large diameter o-rings that may deteriorate over time, which may lead to leaks within the device. Further, conventional devices that deliver two or more gases to the processing region may not mix uniformly in the processing region, thus leading to non-uniform deposition on the substrate.

Therefore, there is a continuing need for a gas distribution device that delivers at least two gases into a processing region without commingling of the gases prior to reaching the processing region while controlling the temperature of the gases. In addition, there is a need for a gas distribution device that seals without the use of large o-rings.

### SUMMARY OF THE INVENTION

Embodiments described herein relate to an apparatus and method for delivering process fluids to a processing chamber for deposition of a film on a substrate, etching a substrate, and other processes.

In the present disclosure, an apparatus for delivering a process fluid to a processing chamber is described. The apparatus includes a first manifold having a plurality of isolated fluid channels at least partially formed therein, and a second manifold coupled to the first manifold, wherein a portion of the plurality of isolated fluid channels include a first and second gas channel in communication with the second manifold.

In another embodiment, a lid assembly for a processing chamber is described. The lid assembly comprises an upper manifold having fluidly isolated first and second flow paths defined therethrough, and a lower manifold with a top side coupled to the upper manifold, and a bottom side having a first plurality of outlets fluidly coupled to the first flow path and a second plurality of outlets fluidly coupled to the second flow path, respectively, wherein the lower manifold comprises a plurality of concentric rings having an inner surface in sealing contact with an outer surface of an adjoining ring adapted to form a material to material seal therebetween.

In the present disclosure, an apparatus for delivering a process fluid to a processing chamber is described. The apparatus includes a manifold assembly with a top side and a bottom side, the top side having a plurality of fluidly isolated circular channels partially formed thereon, and the bottom side having annular outlets formed therein; and a lid plate having a top, a bottom, and an edge, wherein the bottom of the lid plate is coupled to the top side of the manifold assembly, and the lid plate has at least two gas passages and a plurality of thermal control fluid passages formed therethrough in fluid communication with the plurality of circular channels.

In another embodiment, a lid assembly for a processing chamber is described. The lid assembly includes an upper manifold having a plurality of fluidly isolated channels partially formed therein, and a lower manifold coupled to the upper manifold, wherein a first portion of the plurality of fluidly isolated channels comprise first and second gas channels in fluid communication with the lower manifold, and a second portion of the plurality of fluidly isolated channels comprise a plurality of thermal control channels.

In the present disclosure, an apparatus for delivering a process fluid to a processing chamber is described. The apparatus includes a manifold assembly with a top side and a bottom side, the top side having a plurality of fluidly isolated circular channels partially formed thereon, and the bottom side having annular outlets formed therein, and a lid plate having a top, a bottom, and an edge, wherein the bottom of the lid plate is coupled to the top side of the manifold assembly, and the lid plate has at least two gas passages and a plurality of thermal control fluid passages formed therethrough in fluid communication with the plurality of circular channels.

In the present disclosure, a method for making a gas distribution plate is described. The method includes providing a lid plate having a plurality of radial gas passages formed therein, providing a first manifold having a plurality of circular channels formed therein, wherein a portion of the plurality of circular channels define first and second gas channels, providing a second manifold having a plurality of annular grooves formed therein, wherein a the first and second gas channels are in fluid communication with the plurality of annular grooves, and coupling the first and second manifolds to form a gas distribution plate.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments. Nonetheless, the teachings of the present invention can be readily understood by considering the following detailed description in conjunction with the accompanying drawings, in which:
Figure 1 is a schematic cross-sectional view of one embodiment of a processing chamber;
Figure 2 is a cross-sectional view of the processing chamber shown in Figure 1 that has been rotated along a longitudinal axis;
Figure 3A is a schematic top view of one embodiment of an upper manifold;
Figure 3B is a schematic top view of the upper manifold shown in Figure 3A;
Figure 3C is another schematic top view of the upper manifold shown in Figure 3A;
Figure 4A shows an exploded isometric view of one embodiment of a lid assembly;
Figure 4B is a detail cross-sectional schematic view of a component of the lid assembly; and
Figure 5 is a detail view of one portion of a lid assembly that can be used to practice this invention.

To facilitate understanding, identical reference numerals have been used, where possible, to designate identical elements that are common to the figures. It is also contemplated that elements disclosed in one embodiment may be beneficially utilized on other embodiments without specific recitation.

### DETAILED DESCRIPTION

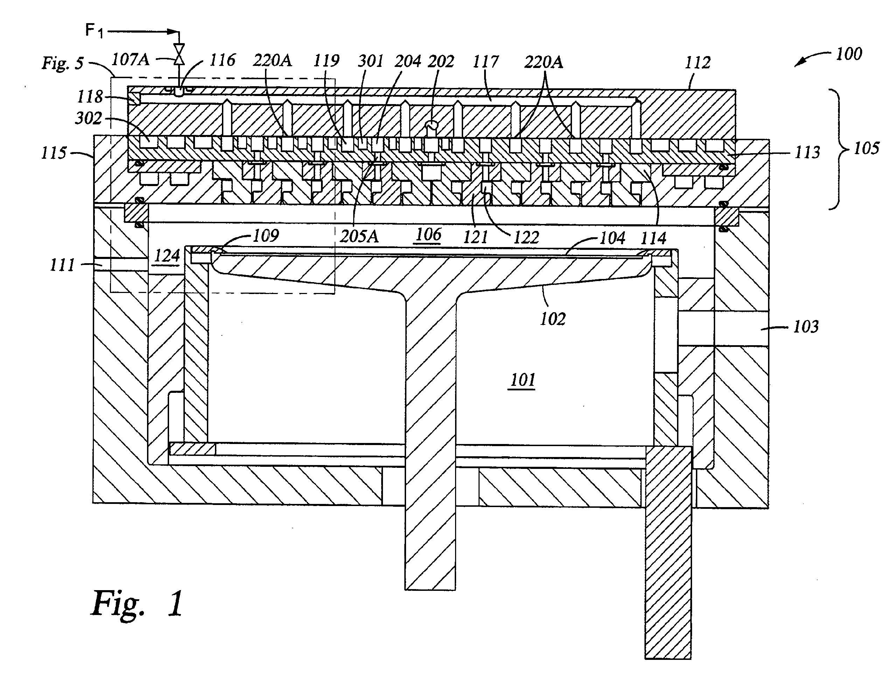

Figure 1 is a cross-sectional view of one embodiment of a processing chamber 100. The processing chamber 100 includes a substrate support 102 disposed within an interior volume 101. A substrate 104, such as a semiconductor wafer, may enter and exit the interior volume 101 by an opening 103 disposed in a wall of the processing chamber 100. Chamber 100 also includes a lid assembly 105 coupled to an upper surface thereof, which forms a boundary for at least a portion of the interior volume 101. In this embodiment, lid assembly 105 comprises a lid plate 112, an upper manifold 113 in fluid communication with lid plate 112, a lower manifold 114 in fluid communication with upper manifold 113, and a lid ring 115.

In one embodiment, a lower surface of the lid assembly 105 and the upper surface of the substrate 104 define a processing region 106. Lower manifold 114 of lid assembly 105 is in fluid communication with processing region 106. In a specific embodiment, the processing chamber 100 includes an annular member, such as a shadow ring 109, which circumscribes a portion of the substrate support 102 adjacent the substrate 104. The shadow ring 109 is adapted to contact the substrate support 102 as the substrate support is raised to a processing position. When the substrate support 102 is raised, a peripheral portion of the shadow ring 109 substantially isolates the lower portion of the substrate support 102 from the processing region 106. This isolation prevents or minimizes the introduction of process gases in portions of the interior volume 101. The reduction in the volume of the interior volume 101, as defined by the processing region 106, reduces the volume of process gases provided to the processing chamber 100.

In one embodiment, the volume of processing region 106 is defined by the distance between the top surface of substrate 104 and the lowest surface of lid 105. Substrate support 102 may be raised and lowered before and after processing to allow entry and exit of substrates. Vacuum is maintained in, and any undeposited gases are evacuated from, process chamber 101 through annular vacuum channel 124 and vacuum portal 111, which is coupled to a vacuum pump (not shown).

Substrate support 102 may be formed of conducting or non-conducting materials, such as a metal (e.g. aluminum, steel, stainless steel, nickel, chromium, an alloy thereof or combinations thereof) or ceramic material. Depending on the specific embodiment, substrate 104 may be heated to a desired temperature prior to and/or during a pretreatment step, a deposition step, post-treatment step or other process step used during the fabrication process.

In one example, substrate support 102 may be heated using an embedded heating element (not shown) such as a resistance heater or a conduit formed within substrate support 102 to supply a heating fluid. In another example, substrate support 102 may be heated using radiant heaters such as, for example, lamps (not shown).

Temperature sensors, such as one or more thermocouples (not shown), may also be embedded in substrate support 102 to monitor the temperature of substrate support 102. The measured temperature may be used in a feedback loop to control a power supply for the heating element, such that the temperature of substrate 104 may be maintained or controlled at a desired temperature which is suitable for the particular process application. Substrate lift pins (not shown) may also be disposed in substrate support 102 and are used to raise and lower substrate 104 from the support surface to facilitate transfer of the substrate into and out of the processing chamber 100.

In one embodiment, fluids, such as gases, are introduced to the processing chamber 100 through control valves, such as valve 107A, coupled to inlet 116 of lid assembly 105. Valve 107A is adapted to couple with a process fluid source F₁. Valve 107A may be any control valve for controlling fluid or gas flow, such as a pneumatically, magnetically, or electrically-actuated valve. Control valves may be biased open or closed, and actuated open or closed in short intervals to provide pulses of gases or continuous streams. Suitable valves are available from Fujikin, Inc., of Osaka, Japan, and Veriflo Corp., of Richmond, California.

Atomic layer deposition (ALD) processes utilize control valves, such as the valve 107A, to generate pulses of gas to the processing region 106. For example, valve 107A may be configured to provide an opened/closed cycle within a range from 10 milliseconds to 5 seconds. In one example, the valve may be quickly pulsed for less than about 1 second, such as within a range from about 10 milliseconds to about 1 second, for example, from about 50 milliseconds to 700 milliseconds, or from about 100 milliseconds to about 500 milliseconds. In another example, the valve may be pulsed slower, such as for more than about 1 second, such as within a range from about 1 second to about 5 seconds, for example, from about 1.5 seconds to 4 seconds, or from about 2 seconds to about 3 seconds.

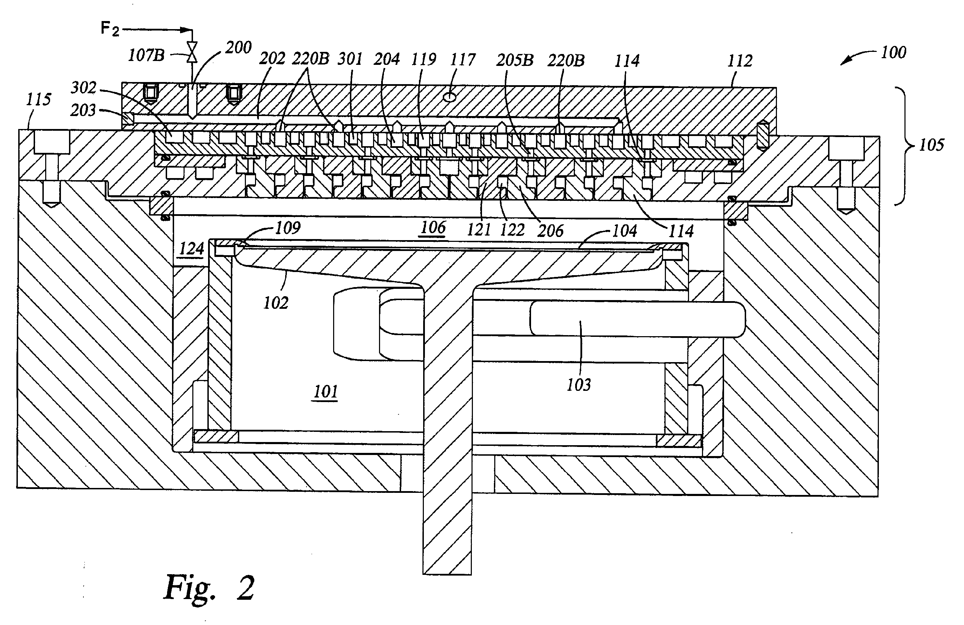

Figure 2 is a cross-sectional view of another embodiment of processing chamber 100 of Figure 1 that has been rotated along a longitudinal axis. In addition to inlet 106 (Figure 1), the lid assembly also includes inlet 200. Inlet 200 is adapted to couple with valve 107B, which in turn is coupled with a fluid source F₂ that is distinct from the source F₁ coupled with valve 107A (Figure 1). In one embodiment, valve 107B and 107A are separate but similar, each capable of providing pulses or continuous flow of fluids or gases as described above. Such a system can be used to flow two gases simultaneously through two separated flow paths. Embodiments with more than two gas pathways are also contemplated by extension from the embodiment shown by Figures 1 and 2.

The embodiments shown in Figures 1 and 2 can be configured to deposit material on a substrate during an atomic layer deposition (ALD) process, chemical vapor deposition (CVD) process, or a metal-organic or organic-metallic CVD (MOCVD or OMCVD) process. Generally, embodiments described herein may be used in high or low pressure processes, high or low temperatures, and with continuous or pulsed, simultaneous or alternating gas flow. Fluid sources F₁ and F₂ coupled to valves 107A, 107B may provide metal halides, such as hafnium tetrachloride (HfCl₄), tungsten hexafluoride (WF₆), or tungsten hexachloride (WCl₆), metal carbonyls, such as tungsten carbonyl (W(CO)₆), reducing compounds, such as ammonia (NH₃), hydrogen (*i.e*. H₂ or atomic-H), hydrazine (N₂H₄), silane (SiH₄), disilane (Si₂H₆), trisilane (Si₃H₈), tetrasilane (Si₄H₁₀), dimethylsilane (SiC₂H₈), methyl silane (SiCH₆), ethylsilane (SiC₂H₈), chlorosilane (ClSiH₃), dichlorosilane (Cl₂SiH₂), hexachlorodisilane (Si₂Cl₆), borane (BH₃), diborane (B₂H₆), triborane, tetraborane, pentaborane, triethylborane (Et₃B), derivatives, plasmas, or combinations thereof, oxidizing compounds, such as oxygen (O₂), ozone (O₃), water (H₂O), nitrous oxide (N₂O), nitric oxide (NO), nitrogen dioxide (NO₂), derivatives or combinations thereof, and carrier gases, such as helium, argon, neon, nitrogen, hydrogen, and other chemical precursors, such as metal-organic or organic-metallic precursors, such as metal alkyls, amidos, imidos, arenes, aryls, or derivatives or combinations thereof. Substrates on which embodiments of the invention may be useful include, but are not limited to semiconductor wafers, such as crystalline silicon (e.g., Si<100> or Si<111>), silicon oxide, strained silicon, silicon nitride, silicon germanium, germanium, gallium arsenide, glass, sapphire, metals, metal alloys, metal nitrides, doped or undoped polysilicon, doped or undoped silicon wafers and patterned or non-patterned wafers. Substrates may be exposed to a pretreatment process to polish, etch, reduce, oxidize, hydroxylate, anneal and/or bake the substrate surface.

Referring to Figures 1 and 2, one embodiment of the lid assembly 105 includes a lid plate 112, a first or upper manifold 113, a second or lower manifold 114, and a lid ring 115. The lid plate 112 includes two lateral conduits, such as passage 117 and 202 that are in fluid communication with processing region 106 through upper manifold 113 and lower manifold 114. The passages 117, 202 may be radially arranged in different planes of the lid plate 112. The lid plate 112 may be formed by any suitable means, such as machining, casting, molding, brazing welding, or a combination thereof. Passages 117 and 202 may be formed in lid plate 112 by any conventional means, including drilling and milling and, in one embodiment, are offset by about 45 degrees and are spaced above and below each other. In one embodiment, passages 117 and 202 are formed by using a gun-drill.

The lid plate 112 may be formed from materials such as aluminum, stainless steel, nickel, alloys or combinations thereof, or a ceramic material. In one embodiment, when passages 117 and 202 are drilled, the open end of the passages 117, 202 are sealed by plugs 118 and 203. Plugs 118, 203 may be formed from a metal, such as those listed above, ceramic, or organic or inorganic polymer material. Plugs 118, 203 are typically made of a material having a similar coefficient of expansion as the material of lid plate 112. Other methods of forming inlets and manifolds in lid plate 112, such as casting, welding, or brazing, may not require plugs to prevent gas escaping.

In one embodiment, lid plate 112 includes two gas inputs 116 and 200 fluidly coupled to valves 107A, 107B, through which two fluids, which may be in gas or vapor phase, are introduced to chamber 100. The inputs 116 and 200 are connected to passages 117 and 202, respectively, which are in fluid communication with processing region 106. Thus, gas from source F₁ passes through valve 107A coupled with input 116 into passage 117. Gas from source F₁ then passes from passage 117 into openings 220A and flows into channels 119 formed in the upper manifold 113. Gas from source F₂ passes through valve 107B coupled with input 200 into passage 202. Gas from source F₂ then passes from passage 202 into opening 220B and flows into channels 204 formed in the upper manifold 113, and as gas from sources F₁ and F₂ reach upper manifold 113, the gases remain separated in two distinct flow paths.

In one embodiment, upper gas channels 119 and 204 are arranged in a pattern of circular channels in upper manifold 113. The circular channels 119, 204 are coupled to the lower manifold through holes 205A and 205B, as will be explained in detail below.

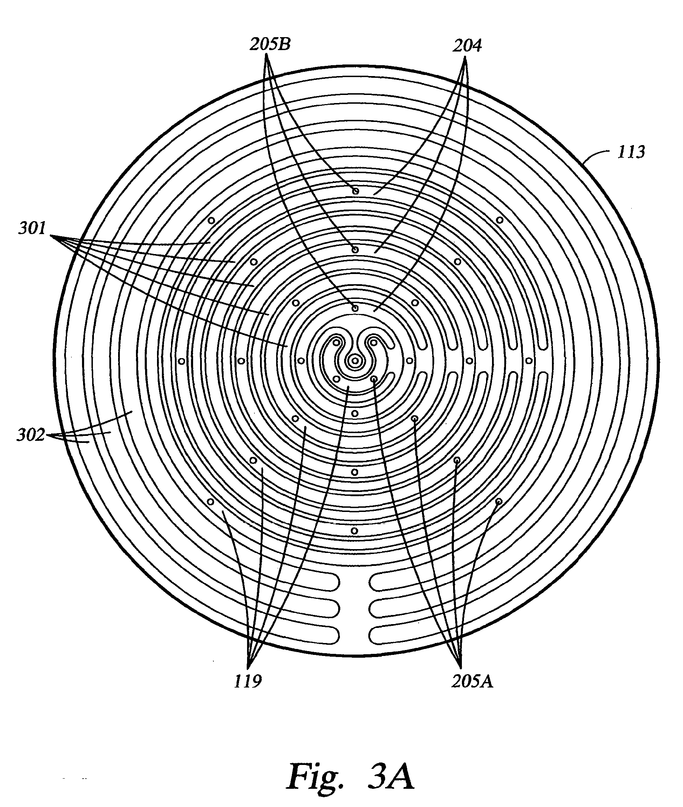

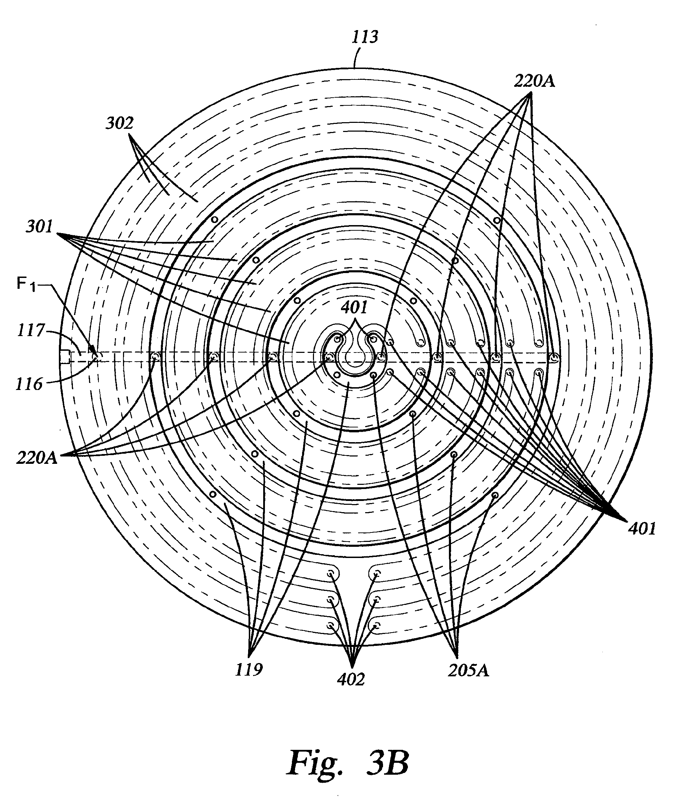

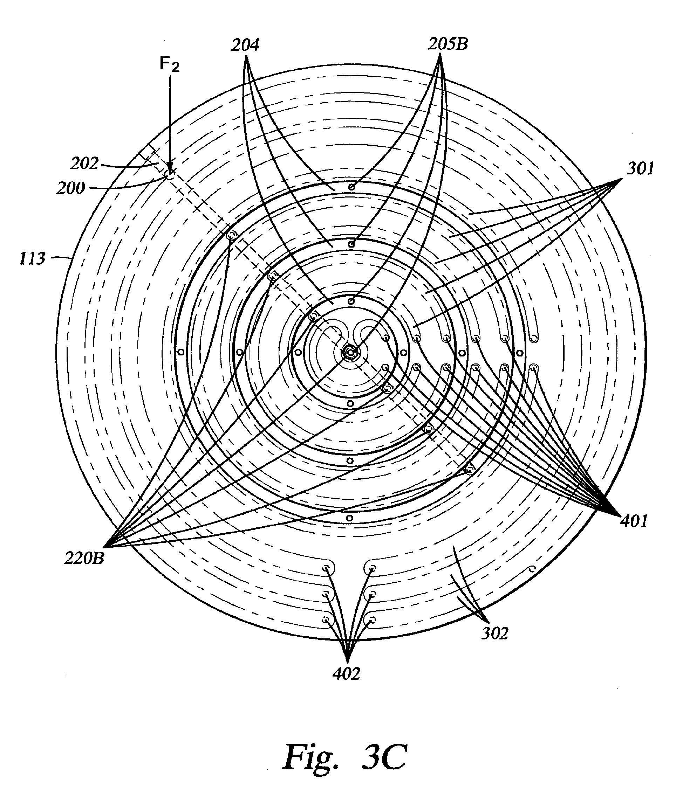

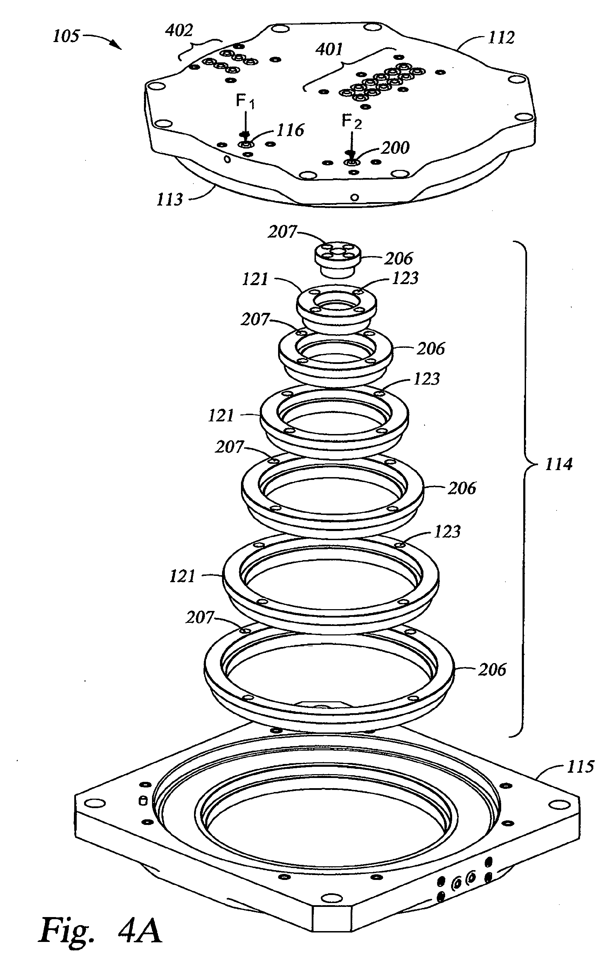

Figure 3A is a top view of one embodiment of upper manifold 113. Upper manifold 113 includes a plurality fluid channels 301 disposed between and isolated from upper gas channels 119 and 204. The upper manifold 113 also includes a plurality of outer fluid channels 302. Each of the fluid channels 301, 302 provide a conduit for a thermal control fluid to be flowed therein, thus providing enhanced thermal control of the upper manifold 113. Thermal control fluid may be in a liquid or gas. Liquids that may be used include water, such as de-ionized water, oil, alcohols, glycols, glycol ethers, other organic solvents, supercritical fluids (*e.g*., CO₂) derivatives thereof or mixtures thereof. Gases may include nitrogen, argon, air, hydrofluorocarbons (HFCs), or combinations thereof. Thermal control fluids enter and exit upper manifold 113 through ports 401, 402 (Figures 3B, 3C, and 4A) formed in lid plate 112. The upper manifold 113 is made of process resistant and/or chemistry compatible materials, such as aluminum, stainless steel, a ceramic material, or combinations thereof. The upper manifold 113 may be molded, cast, machined, or a combination thereof. In one embodiment, lid plate 112 and upper manifold 113 may be brazed together to form a singular plate with gas delivery and thermal control features integrated. In one embodiment, the mating surfaces of the upper manifold 113 and lid plate 112 form a shear seal. The surfaces may be finished by lapping or other suitable technique.

Each of the upper gas channels 119, 204 and fluid channels 301, 302 define conduits having one side adapted to be sealed by a lower surface of the lid plate 112 when coupled thereto. Upper gas channels 119, 204 and fluid channels 301, 302 may have a cross-sectional shape including U-shaped having rounded corners, a U-shape having substantially square corners, or a combination thereof. In a center portion of the upper gas manifold 113, each of the upper gas channels 119, 204 are separated by fluid channels 301. Annular walls between upper gas channels 119, 204 and fluid channels 301 provide separate flow paths for respective gases and fluids. The upper gas channels 119, 204 and fluid channels 301, 302 are separated and sealed when the lid plate 112 is coupled to the upper manifold 113 to prevent contamination between the thermal control fluid and the gases.

The configuration of fluid channels 301, 302, and gas channels 119, 204 are not limited to the number and configuration as shown. Greater or fewer fluid channels 301, 302, and gas channels 119, 204 may be used, and the shape of the fluid channels 301, 302, and gas channels 119, 204 may be formed in the upper manifold 113 in any shape desired. For example, more inner channels 301 and fewer outer channels 302 may be used, or vice versa. Other embodiments may have channels with different cross-sectional shapes, such as complete circles. Still other embodiments may include more vertical configurations, such as layers of channels formed within one of the lid plate 112 and/or upper manifold 113.

Figure 3B is a schematic top view of upper manifold 113 showing the position of passage 117 in relation to gas channels 119. In this embodiment, fluid channels 301, 302 are shown in phantom, and gas channels 204 are not shown, for clarity. As described above, openings 220A of passage 117 are in fluid communication with gas channels 119. Holes 205A, which are in fluid communication with lower manifold 114, are positioned at about a 45 degree offset from the openings 220A. In this manner, gas from source F₁ may be introduced through valve 107A, flow through gas channels 119, and be delivered to lower manifold 114 without mixing with gas from source F₂ and thermal control fluids. The embodiment is not limited to the number and positioning of holes 205A as more or less holes 205A may be added at different radial positions and/or different angular offsets within the gas channels 119.

Figure 3C is a schematic top view of upper manifold 113 showing the position of passage 202 in relation to gas channels 204. In this embodiment, fluid channels 301, 302 are shown in phantom, and gas channels 119 are not shown, for clarity. As described above, openings 220B of passage 202 are in fluid communication with gas channels 204. Holes 205B, which are in fluid communication with lower manifold 114, are positioned at about a 45 degree offset from the openings 220B. In this manner, gas from source F₂ may be introduced through valve 107B, flow through gas channels 204, and be delivered to lower manifold 114 without mixing with gas from source F₁ and thermal control fluids. The embodiment is not limited to the number and positioning of holes 205B as more or less holes 205B may be added at different radial positions and/or different angular offsets within the gas channels 204.

Figure 4A is an exploded isometric view of one embodiment of a lid assembly 105. Lower manifold 114 is shown exploded into its constituent nested rings 121 and 206, which, when assembled, form lower manifold 114. In one embodiment, rings 121, 206 are precision-manufactured to seal without the use of o-rings, gaskets, or the like. In one embodiment, the rings 121, 206 form a shear seal between portions of inner and outer diameters that are in contact. The rings 121, 206 may be formed by lapping and inner and outer diameters of each ring 121, 206 are held to tolerances wherein a material to material seal is formed at points where the rings contact. The material to material seal provides a substantial gas-tight seal that prevents and/or minimizes leakage between gas passages defined between rings 121, 206.

Apertures 123 and 207 in rings 121 and 206 are in fluid communication with channels 119 and 204 of upper manifold 113 via openings 205A, 205B, respectively. Thus, gas from inputs 116 and 200 of lid plate 112 flows through upper manifold 113 into lower manifold 114. Gases from sources F₁ and F₂ flow through inputs 116 and 200, respectively, of lid plate 112. Thermal cooling fluids flow through portals 401 and 402 of lid plate 112. The arrangement of openings and passages in the various components may be varied in numerous ways to create different embodiments. For example, more openings may be provided in any geometrically optimum pattern. Likewise, openings may be aligned, as shown in the figures, or they may be staggered. Openings may also be sized to optimize flow and pressure distributions throughout the apparatus.

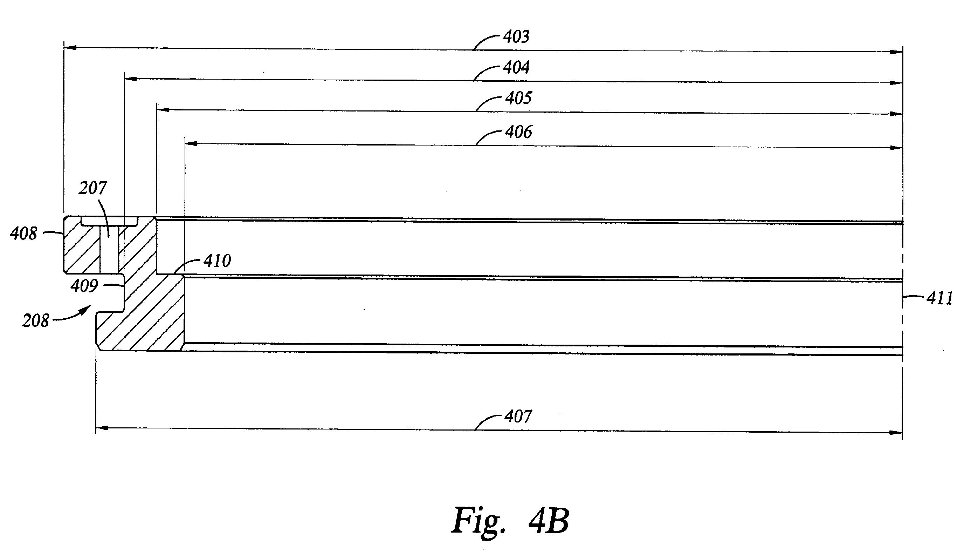

Figure 4B is a partial cross-sectional schematic of one embodiment of a ring 206, which is similar in construction to ring 121. In this embodiment, ring 206 is precision-ground, lapped, or polished along inner and outer diameters to create a shear seal with the mating ring to minimize and/or prevent gas leaking through lower manifold 114. Ring 206 has an extended top portion 408 that forms a ledge around the perimeter of the ring. The aperture 207 is formed through the top portion 408. The top portion 408 is defined by a first outer radius 403 and a first inner radius 405, measured with reference to the centerline 411 of the ring. The ring 206 also includes a bottom portion defined by a second outer radius 407 and a second inner radius 406. Each ring 206 also includes a gap 208 defined by a third outer radius 404. The difference of the first inner radius 405 and second inner radius 406 result in a shoulder 410 being defined on the inside of the ring 206. The radii described above in reference to ring 206 may be varied to form different embodiments of rings 121 and 206.

Rings 121 and 206 may be formed from hard materials that withstand temperatures in excess of 1000 degrees C with a low coefficient of thermal expansion. The materials may be hard materials, such as silicon carbide, silicon graphite, sapphire, quartz, a ceramic material or other hard materials.

By extension of the embodiment described in Figure 4B, each ring comprises a first outer diameter and a second outer diameter, having a third outer diameter therebetween, wherein the third diameter is the gap 208. Each ring also comprises a first inner diameter and a second inner diameter to form a shoulder 410. As will be described in detail below, the first outer diameter of one ring is adapted to press or slip-fit with the first inner diameter of another ring.

The rings 121, 206 are adapted to fit together to form lower manifold 114 wherein the extended top portion 408 of one ring abuts the shoulder area 410 of another ring. In one embodiment, the first outer radius 403 of one ring, measured from the centerline 411, is slightly less than the first inner radius 405 of another ring, wherein the diameters of the constituent rings enable a press-fit. The difference between the first inner diameter and the second inner diameter, and the surface finish of the rings, enable a material to material seal to produce a substantial gas-tight seal between adjacent rings.

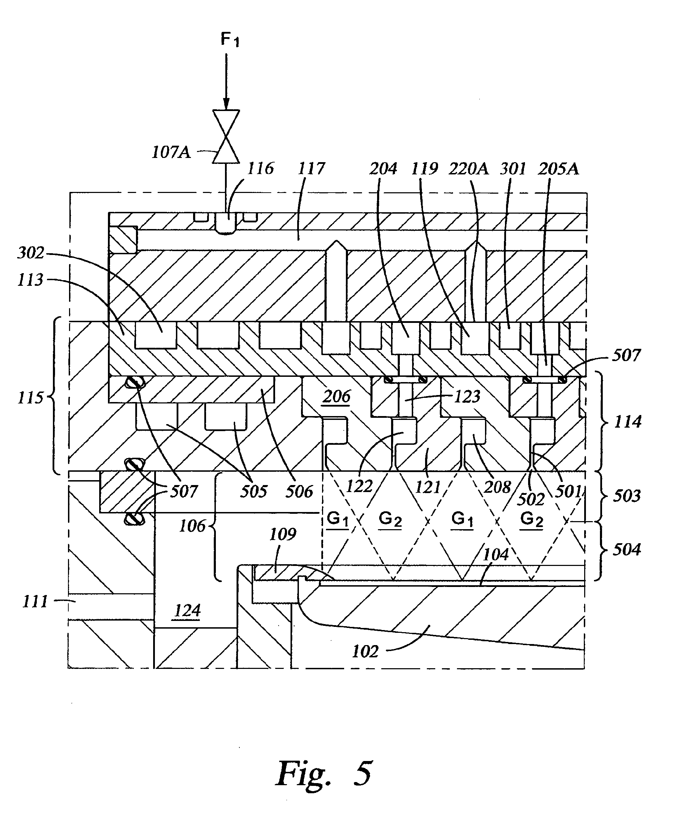

As the rings 121, 206 are sequentially fitted together, the difference between the second outer radius 407 of one ring and second inner radius 406 of an adjacent ring form annular groove 501 (Figure 5). The width of annular groove 501 is generally between about 0.010 mils to about 0.060 mils, such as about 0.030 mils. Annular groove 501 is in fluid communication with gap 208, which is in communication with upper manifold 113 via aperture 207.

Figure 5 shows a detailed cross-section view of lid assembly 105. The shape of rings 121 and 206 are formed to include annular gaps 122 and 208 as described above. Annular gaps 122 and 208 are in fluid communication with annular grooves 501, which are in fluid communication with processing region 106. In this embodiment, lower manifold 114 couples with lid plate 115, which comprises additional water conduits 505, and a containment ring 506. The lid assembly is sealed around a perimeter and various interior portions using o-rings 507, in the locations indicated.

In one embodiment, annular grooves 501 terminate in an annular nozzle 502. In some embodiments, geometry of annular nozzles 502 may be designed to create a specific spread pattern of gas within processing volume 106. This spread pattern, substantially triangular or trapezoidal in cross-sectional shape, creates a separation zone 503 and a mixing zone 504, wherein the distinct gases G₁ and G₂ from sources F₁ and F₂ are not mixed until reaching the mixing zone 504. This enables enhanced control of reactive species within processing volume 106, which may eliminate or minimize any unwanted deposition on surfaces other than substrate 104. The sidewalls of the nozzles 502 may be angled from about 15 degrees to about 90 degrees, such as about 50 degrees to about 70 degrees, for example, about 60 degrees. In one embodiment, the surface of the nozzles 502 may be modified to change the flow attributes and/or the geometry of the spread pattern and enhance flow characteristics. In one aspect, the surface may be roughened to facilitate a more laminar flow. In another aspect, the surface may be smoothed or not roughened to provide a faster, more turbulent flow of gasses. For example, the nozzles 502 may include a surface that has been bead, ice, or grit blasted.

In operation, gas from source F₁ passes through valve 107A coupled with input 116 into passage 117. Gas from source F₁ then passes from passage 117 into opening 220A for introduction into the upper manifold 113. Gas from source F₂ passes through valve 107B coupled with input 200 into passage 202. Gas from source F₂ then passes from passage 202 into opening 220B for introduction into the upper manifold 113 and as gas from sources F₁ and F₂ reach upper manifold 113, the gases remain isolated in two separate flow paths. Gas from sources F₁ and F₂ enters the upper manifold 113 through upper gas channels 119 and 204, respectively. Holes 205A, 205B, which are in fluid communication with lower manifold 114, allow gas from sources F₁ and F₂ to be flowed to apertures 123, 207, respectively, formed in the lower manifold 114 (207 not shown in this view). Apertures 123 and 207 (not shown) are in fluid communication with annular gaps 122 and 208, respectively, which are in communication with annular grooves 501. Gas from sources F₁ and F₂ flow through the annular grooves 501 and are delivered to the processing region 106 by the annular nozzles 502. In this manner, gas from sources F₁ and F₂ are not mixed until reaching the mixing zone 504.

The embodiments described herein enable the delivery of two distinct gases to a processing region without mixing until directly above the face of a substrate. The thermal control aspects provided herein also enable temperature control of the various gases provided to the processing region. This provides enhanced control of processes within the chamber, such as deposition, etch processes, and the like. For example, gas mixing may be controlled such that reactions in the processing region may be enhanced. Unwanted deposition on chamber components and particle generation may be minimized. This increases throughput by the reduction of particles and minimizing downtime for chamber cleaning.

While the foregoing is directed to embodiments of the present invention, other and further embodiments of the invention may be devised without departing from the basic scope thereof, and the scope thereof is determined by the claims that follow.

## Claims

1. A lid assembly for a processing chamber, comprising:
an upper manifold having fluidly isolated first and second flow paths defined therethrough; and
a lower manifold with a top side coupled to the upper manifold, and a bottom side having a first plurality of outlets fluidly coupled to the first flow path and a second plurality of outlets fluidly coupled to the second flow path, respectively, wherein the lower manifold comprises a plurality of concentric rings each having an inner surface in sealing contact with an outer surface of a respective adjoining ring and forming a material to material seal therebetween.

2. The lid assembly of claim 1, wherein the upper manifold has a plurality of circular channels formed therein, wherein a first portion of the plurality of circular channels are in fluid communication with respective annular gaps formed between the plurality of concentric rings.

3. The lid assembly of claim 1, wherein the upper manifold includes a plurality of fluid channels.

4. The lid assembly of claim 1, wherein the upper manifold is attached or coupled to a lid plate.

5. The lid assembly of claim 4, wherein the lid plate includes a plurality of radial gas passages formed therein .

6. The lid assembly of claim 4, wherein the lid plate includes a containment ring.

7. The lid assembly of claim 1, further comprising:
a lid plate having a plurality of openings formed therein for fluidly coupling two or more gases to the plurality of concentric rings.

8. The lid assembly of claim 7, wherein the lid plate is brazed to the upper manifold.

9. The lid assembly of claim 1, wherein the plurality of outlets comprise annular passages.

10. The lid assembly of claim 1, wherein the plurality of outlets have angled edges.

11. The lid assembly of claim 1, wherein the upper manifold comprises a plurality of fluidly isolated channels partially formed therein defining a portion of the first and second flow paths.

12. The lid assembly of claim 11, wherein a first portion of the plurality of fluidly isolated channels include first and second gas channels in fluid communication with the lower manifold, and a second portion of the plurality of fluidly isolated channels include a plurality of thermal control channels.

13. The lid assembly of claim 12, wherein each of the first and second gas channels are separated by one of the plurality of thermal control channels.

14. The lid assembly of claim 12, wherein the lower manifold further comprises a first plurality of annular grooves in fluid communication with the first gas channels and a second plurality of annular grooves in fluid communication with the second gas channels, wherein the first and second plurality of annular grooves are fluidly isolated from one another.

15. The lid assembly of claim 12, wherein the upper manifold couples to a lid plate having a plurality of radial passages formed therein in communication with the first portion of the plurality of fluidly isolated channels.

## Patentansprüche

1. Deckelsystem für eine Bearbeitungskammer, Folgendes aufweisend:
einen oberen Verteilraum mit einem durch diesen hindurch gebildeten, fluidtechnisch getrennten ersten und zweiten Strömungsweg; und
einen unteren Verteilraum mit einer Oberseite, die an den oberen Verteilraum angeschlossen ist, und einer Unterseite mit mehreren ersten Auslässen, die fluidtechnisch an den ersten Strömungsweg angeschlossen sind, bzw. mehreren zweiten Auslässen, die fluidtechnisch an den zweiten Strömungsweg angeschlossen sind, wobei der untere Verteilraum mehrere konzentrische Ringe aufweist, wovon jeder eine Innenfläche hat, die in abdichtendem Kontakt mit einer Außenfläche eines jeweiligen benachbarten Rings steht und eine Abdichtung Material an Material zwischen diesen bildet.

2. Deckelsystem nach Anspruch 1, wobei der obere Verteilraum mehrere kreisförmige Kanäle in sich ausgebildet hat, wobei ein erster Teil der mehreren kreisförmigen Kanäle in Fluidverbindung mit jeweiligen Ringspalten steht, die zwischen den mehreren konzentrischen Ringen gebildet sind.

3. Deckelsystem nach Anspruch 1, wobei der obere Verteilraum mehrere Fluidkanäle enthält.

4. Deckelsystem nach Anspruch 1, wobei der obere Verteilraum an einer Deckelplatte befestigt oder an diese angeschlossen ist.

5. Deckelsystem nach Anspruch 4, wobei die Deckelplatte mehrere radiale Gasdurchlässe in sich ausgebildet hat.

6. Deckelsystem nach Anspruch 4, wobei die Deckelplatte einen Sicherheitsumschließungsring enthält.

7. Deckelsystem nach Anspruch 1, darüber hinaus aufweisend:
eine Deckelplatte mit mehreren darin ausgebildeten Öffnungen, um zwei oder mehr Gase fluidtechnisch zu den mehreren konzentrischen Ringen zu lenken.

8. Deckelsystem nach Anspruch 7, wobei die Deckelplatte an den oberen Verteilraum hartgelötet ist.

9. Deckelsystem nach Anspruch 1, wobei die mehreren Auslässe ringförmige Durchlässe umfassen.

10. Deckelsystem nach Anspruch 1, wobei die mehreren Auslässe schräge Kanten haben.

11. Deckelsystem nach Anspruch 1, wobei der obere Verteilraum mehrere teilweise in sich ausgebildete, fluidtechnisch getrennte Kanäle aufweist, die einen Abschnitt des ersten und zweiten Strömungswegs bilden.

12. Deckelsystem nach Anspruch 11, wobei ein erster Abschnitt der mehreren fluidtechnisch getrennten Kanäle einen ersten und zweiten Gaskanal enthält, die in Fluidverbindung mit dem unteren Verteilraum stehen, und ein zweiter Abschnitt der mehreren fluidtechnisch getrennten Kanäle mehrere Wärmeregelungskanäle enthält.

13. Deckelsystem nach Anspruch 12, wobei der erste und zweite Gaskanal jeweils durch einen der mehreren Wärmeregelungskanäle getrennt sind.

14. Deckelsystem nach Anspruch 12, wobei der untere Verteilraum darüber hinaus mehrere erste Ringnuten, die in Fluidverbindung mit den ersten Gaskanälen stehen, und mehrere zweite Ringnuten aufweist, die in Fluidverbindung mit den zweiten Gaskanälen stehen, wobei die mehreren ersten und zweiten Ringnuten fluidtechnisch voneinander getrennt sind.

15. Deckelsystem nach Anspruch 12, wobei sich der obere Verteilraum an eine Deckelplatte mit mehreren darin ausgebildeten radialen Durchlässen anschließt, die mit dem ersten Abschnitt der mehreren fluidtechnisch getrennten Kanäle in Verbindung stehen.

## Revendications

1. Ensemble de couvercle pour une chambre de traitement, comprenant :
un manifold supérieur présentant des première et deuxième voies d'écoulement fluidiquement isolées définies à travers lui ; et
un manifold inférieur présentant un côté haut couplé au manifold supérieur, et un côté bas présentant une première pluralité de sorties fluidiquement couplées à la première voie d'écoulement et une deuxième pluralité de sorties fluidiquement couplées à la deuxième voie d'écoulement, respectivement, sachant que le manifold inférieur comprend une pluralité d'anneaux concentriques ayant chacun une surface intérieure en contact hermétique avec une surface extérieure d'un anneau attenant respectif et formant un joint matière contre matière entre eux.

2. L'ensemble de couvercle de la revendication 1, dans lequel le manifold supérieur présente une pluralité de canaux circulaires formés à l'intérieur, une première partie de la pluralité de canaux circulaires étant en communication fluidique avec des interstices annulaires respectifs formés entre la pluralité d'anneaux concentriques.

3. L'ensemble de couvercle de la revendication 1, dans lequel le manifold supérieur inclut une pluralité de canaux de fluide.

4. L'ensemble de couvercle de la revendication 1, dans lequel le manifold supérieur est attaché ou couplé à une plaque de couvercle.

5. L'ensemble de couvercle de la revendication 4, dans lequel la plaque de couvercle inclut une pluralité de passages de gaz radiaux formés à l'intérieur.

6. L'ensemble de couvercle de la revendication 4, dans lequel la plaque de couvercle inclut un anneau de logement.

7. L'ensemble de couvercle de la revendication 1, comprenant en outre :
une plaque de couvercle présentant une pluralité d'ouvertures formées à l'intérieur pour coupler fluidiquement deux gaz ou plus à la pluralité d'anneaux concentriques.

8. L'ensemble de couvercle de la revendication 7, dans lequel la plaque de couvercle est brasée sur le manifold supérieur.

9. L'ensemble de couvercle de la revendication 1, dans lequel la pluralité de sorties comprend des passages annulaires.

10. L'ensemble de couvercle de la revendication 1, dans lequel la pluralité de sorties présente des bords coudés.

11. L'ensemble de couvercle de la revendication 1, dans lequel le manifold supérieur comprend une pluralité de canaux fluidiquement isolés partiellement formés à l'intérieur, définissant une partie des première et deuxième voies d'écoulement.

12. L'ensemble de couvercle de la revendication 11, dans lequel une première partie de la pluralité de canaux fluidiquement isolés inclut des premiers et deuxièmes canaux de gaz en communication fluidique avec le manifold inférieur, et une deuxième partie de la pluralité de canaux fluidiquement isolés inclut une pluralité de canaux de commande thermique.

13. L'ensemble de couvercle de la revendication 12, dans lequel chacun des premiers et deuxièmes canaux de gaz est séparé par un de la pluralité de canaux de commande thermique.

14. L'ensemble de couvercle de la revendication 12, dans lequel le manifold inférieur comprend en outre une première pluralité de rainures annulaires en communication fluidique avec les premiers canaux de gaz et une deuxième pluralité de rainures annulaires en communication fluidique avec les deuxièmes canaux de gaz, la première et la deuxième pluralité de rainures annulaires étant fluidiquement isolées l'une de l'autre.

15. L'ensemble de couvercle de la revendication 12, dans lequel le manifold supérieur se couple à une plaque de couvercle présentant une pluralité de passages radiaux formés à l'intérieur, en communication avec la première partie de la pluralité de canaux fluidiquement isolés.
